# EUROPÄISCHE PATENTSCHRIFT

(11) **EP 0 449 370 B1**
(45) Veröffentlichungstag und Bekanntmachung des Hinweises auf die Patenterteilung: **12.06.1996**
(21) Anmeldenummer: 91200657.4
(22) Anmeldetag: 25.03.1991
(51) Int. Cl.: H03K 5/12, H03K 6/04, H04N 9/64

(54) **Schaltungsanordnung zur Versteilerung von Signalflanken**
Circuit arrangement for steepening signal edges
Circuit pour rendre les flancs des signaux plus raides

(30) Priorität: 27.03.1990 DE 4009730
(43) Veröffentlichungstag der Anmeldung: 02.10.1991
(73) Patentinhaber: Philips Patentverwaltung GmbH, 22335 Hamburg (DE); Philips Electronics N.V., 5621 BA Eindhoven (NL)
(72) Erfinder: Mittelberg, Achim, W-2000 Wedel (Holstein) (DE)
(74) Vertreter: von Laue, Hanns-Ulrich, Dipl.-Ing.

(56) Entgegenhaltungen:
- EP-A- 0 198 103
- EP-A- 0 278 708
- DE-C- 3 541 103

## Beschreibung

Die Erfindung betrifft eine Schaltungsanordnung zum Versteilern von Signalflanken eines als Folge amplitudendiskreter Abtastwerte eines Analogsignals vorliegenden Digitalsignals, insbesondere eines Farbsignals eines Farbfernsehsignals.

Aus der DE-C 35 41 103 ist eine Schaltungsanordnung zum Erhöhen der Schärfe von Farbkanten bekannt, bei der der Verlauf des Helligkeitssignals dazu herangezogen wird, Signalflanken des Farbsignals zu versteilern. Dazu wird die Steilheit des Helligkeitssignals festgestellt und bei Überschreiten eines bestimmten Steilheitsbetrages ein Zähler aktiviert. Während der Zeit, in der der Zähler weiterzählt, wird ein vorher festgehaltener Wert des Farbdifferenzsignals unabhängig von den laufenden Veränderungen des Farbsignals ausgegeben. Nach der Zählung einer bestimmten Anzahl von Takten wird wieder der aktuelle Farbdifferenzsignalwert ausgegeben. Es wird also ausgehend von der Anfangsamplitude des Signals direkt auf den Endwert umgeschaltet. Eine derartige Schaltungsanordnung ist insbesondere nicht in der Lage, sich an ändernde Signalcharakteristiken anzupassen. So bleibt beispielsweise die Länge einer Signalflanke bzw. deren Steilheit unberücksichtigt. Darüber hinaus ist insbesondere bei relativ niederfrequenten Signalflanken, d.h. also solchen, die eine relativ lange Anstiegszeit aufweisen, mit einer Signalverfremdung zu rechnen, da diese ebenfalls der Versteilerung unterzogen werden. Das grundsätzliche Problem der bekannten Schaltungsanordnung liegt jedoch darin, daß sie an das Helligkeitssignal gebunden arbeitet, so daß also Farbänderungen, die nicht mit einer Änderung des Helligkeitssignal einhergehen, nicht versteilert werden können.

Es ist Aufgabe der Erfindung, eine Schaltungsanordnung zu schaffen, bei welcher die oben genannten Probleme nicht auftreten.

Diese Aufgabe ist erfindungsgemäß dadurch gelöst, daß das zu versteilernde Digitalsignal einem Flankendetektor zugeführt wird, welcher während der Zeitspanne, in der eine Flanke des Digitalsignals einen vorgebbaren Steilheitswert überschreitet, ein Markierungssignal abgibt, das die der zu versteilernden Flanke des Digitalsignals entsprechende Sequenz der Abtastwerte im Digitalsignal markiert, daß eine Verzögerungseinrichtung vorgesehen ist, in welcher das Digitalsignal und das Markierungssignal um eine feste Zeitspanne verzögert werden, deren Dauer länger ist als die maximale Zeitdauer der markierten Sequenzen, daß ein FIFO-Speicher vorgesehen ist, in den der Abtastwert des nicht verzögerten Digitalsignals zum Zeitpunkt des Endes der nicht verzögerten, markierten Sequenz eingelesen und zum Zeitpunkt des Beginns der verzögerten markierten Sequenz wieder ausgelesen wird, und daß ein Sequenzgenerator vorgesehen ist, welcher unter Heranziehung des verzögerten Digitalsignals, des verzögerten Markierungssignals und des aus dem FIFO-Speicher ausgelesenen Wertes ein versteilertes Signal generiert und mit Hilfe eines Multiplexers in wenigstens einen Teilabschnitt der markierten Sequenz des verzögerten Digitalsignals anstelle der ursprünglichen Sequenz des Signals einsetzt.

Bei dieser Schaltungsanordnung wird also zunächst zur Detektion einer Flanke in dem zu versteilernden Signal ausschließlich das zu versteilernde Signal selbst herangezogen und nicht etwa ein korrespondierendes Signal, wie beispielsweise ein Helligkeitssignal eines Farbfernsehsignals, das zur Versteilerung eines oder mehrerer Farbsignale herangezogen wird.

Das zu versteilernde Digitalsignal wird einem Flankendetektor zugeführt. In diesem Flankendetektor wird festgestellt, wann das Signal einen vorgebbaren Steilheitswert überschreitet. Während der Zeitspanne, in der das Signal diesen vorgebbaren Wert überschreitet, gibt der Flankendetektor ein Markierungssignal ab. Dieses Signal markiert also diejenige Sequenz, in der sich eine Flanke des zu versteilernden Signals befindet.

Sowohl das zu versteilernde Signal selbst sowie auch das von dem Flankendetektor generierte Markierungssignal werden einer Verzögerungseinrichtung zugeführt, in der sie um eine feste Zeitspanne verzögert werden. Die Wahl dieser Zeitspanne hängt davon ab, wie lang die Sequenzen maximal sind, in denen Flanken zu versteilern sind. In dem Anwendungsbereich der Versteilerung von Farbsignalen eines Farbfernsehsignals beispielsweise ist bekannt, welcher Bandbegrenzung die Farbsignale zuvor unterzogen wurden. Es wird dann insbesondere eine Versteilerung im Bereiche dieser Bandbegrenzung gewünscht sein. In niederfrequenteren Bereichen des Farbsignals, die von der Bandbegrenzung praktisch nicht betroffen sind, wird eine Versteilerung nicht erforderlich sein, so daß sich schon aus diesen Kriterien die Zeitspanne ergibt, die die zu versteilernde Frequenzen maximal aufweisen.

Es ist ferner ein sogenannter FIFO-Speicher vorgesehen, welcher sich dadurch auszeichnet, daß seriell in ihn eingelesene Daten in der gleichen Reihenfolge wieder ausgelesen werden. In diesen FIFO-Speicher wird zum Zeitpunkt des Endes der nicht verzögerten Sequenz, d.h. also zu dem Zeitpunkt, zu dem das Markierungssignal endet, der aktuelle Amplitudenwert des Digitalsignals eingelesen, d.h. es wird dieser Amplitudenwert festgestellt und in den FIFO-Speicher abgespeichert.

Die in die Verzögerungseinrichtung eingelesenen Werte des zu versteilernden Signals und des Markierungssignals werden nach der festen Verzögerungs-Zeitspanne wieder ausgelesen. Während dieses Auslesens wird festgestellt, wann die verzögerte Sequenz beginnt, was beispielsweise anhand des verzögerten Markierungssignals geschehen kann. Sobald dieser Zeitpunkt erreicht ist, wird aus dem FIFO-Speicher der dort zuvor eingelesene Endwert des zu verzögernden Signals ausgelesen. Es stehen somit nun zum Beginn der verzögerten Sequenz sowohl das verzögerte zu versteilernde Signal, das verzögerte Markierungssignal und der Endwert des zu versteilernden Digitalsignals, das dieses am Ende der Sequenz einnehmen wird, zur Verfügung.

Diese Signale werden nun in einem Sequenzgenerator weiterverarbeitet, welcher in der durch das verzögerte Markierungssignal angegebenen Zeitspanne einen versteilerten Signalverlauf des zu versteilernden Signals generiert. Dies kann beispielsweise im einfachsten Falle durch ein digitales Filter geschehen. In dem Sequenzgenerator ist ferner ein Multiplexer vorgesehen, welcher anhand der durch das verzögerte Markierungssignal angegebenen Zeitspanne vom verzögerten Digitalsignal, also von dem unveränderen Digitalsignal, auf das versteilerte Digitalsignal umschaltet. Es ist hierbei nicht unbedingt erforderlich, daß diese Umschaltung während der gesamten, von dem Markierungssignal angegebenen Zeitspanne geschieht; je nach Anwendung kann es auch vorteilhaft sein, zu Beginn und zu Ende der Sequenz auf den Anfangswert bzw. den Endwert des zu versteilernden Signals zu schalten und nur in der Mitte der markierten Sequenz auf das versteilerte Signal umzuschalten.

Diese Schaltungsanordnung weist insbesondere den Vorteil auf, daß sie sich nur an den Werten des zu versteilernden Signals orientiert und nicht an anderen korrespondierenden Signalen. In dem Anwendungsbereich der Versteilerung eines Farbsignals eines Farbfernsehsignals werden also auch Flanken detektiert, die in dem Farbsignal vorhanden sind, die jedoch nicht mit korrespondierenden Flanken eines Helligkeitssignals einhergehen. Da in dem optischen Bildeindruck gerade solche Flanken aufgrund der starken Bandbegrenzung der Farbsignale besonders stark verwischt sind, kann die Schaltungsanordnung hier besonders vorteilhaft wirksam werden.

Ferner schaltet die Schaltungsanordnung nicht zwischen bestimmten Anfangs- und Endwerten des Signals um, sondern generiert in der Zeitspanne der detektierten Sequenz einen versteilerten Verlauf des ursprünglichen Signals. Somit werden verschiedene Signalverläufe des ursprünglichen Signals berücksichtigt, und es erfolgt nicht nur ein einfaches Umschalten zwischen bestimmten Werten. Somit ist eine wesentlich höhere Signaltreue gegeben als beim einfachen Umschalten zwischen zwei Werten. Ein weiterer Vorteil der Schaltungsanordnung besteht darin, daß sie sich an der Länge der zu versteilernden Flanke, d.h. also an deren Anstiegszeit orientiert, und die Versteilerung des Signals an diese anpaßt.

Die Schaltungsanordnung arbeitet vom Eingang bis zum Ausgang mit einer festen Verzögerung, die für andere, gegebenenfalls parallel zu verarbeitende Signale berücksichtigt werden kann.

Die Versteilerung des zu versteilernden digitalen Signals kann, wie nach einer Ausgestaltung der Erfindung vorgesehen ist, vorteilhafter Weise dadurch vorgenommen werden, daß in dem Sequenzgenerator das versteilerte Signal mittels Addition des verzögerten Digitalsignals mit dessen zweiter Ableitung generiert wird. Bei dieser Art der Generierung des versteilerten Signals besteht insbesondere die Möglichkeit, das Maß der gewünschten Versteilerung dadurch zu bestimmen, daß gemäß einer weiteren Ausgestaltung der Erfindung bei der Addition eine Gewichtung der beiden Signalanteile vorgenommen werden kann. Diese Gewichtung kann für den Anwendungsbereich der Versteilerung eines Farbsignals in einem Fernsehempfänger von dessen Bediener je nach gewünschtem Schärfeeindruck vorgenommen werden.

Nach einer weiteren Ausgestaltung ist vorgesehen, daß die Gewichtung der beiden Signalanteile in Abhängigkeit des Maßes der gewünschten Flankenversteilerung vorgenommen wird.

Die Versteilerung der Signalflanken des Digitalsignals dient in den meisten Anwendungsbereichen dazu, eine zuvor vorgenommene Bandbegrenzung des Signals wieder näherungsweise auszugleichen. So wird beispielsweise ein Farbsignal eines Farbfernsehsignals einer recht starken Bandbegrenzung unterzogen. Es ist nun wünschenswert, insbesondere in dem etwas unterhalb der oberen Bandgrenze liegenden Frequenzbereich eine Versteilerung des Signals vorzunehmen. Dagegen ist im unteren Frequenzbereich des Signals eine Versteilerung nicht wünschenswert, da in diesem Frequenzbereich keine wesentliche Veränderung des Signals durch die Bandbegrenzung stattgefunden hat. Die erfindungsgemäße Schaltungsanordnung bietet nun die Möglichkeit, die Versteilerung des Signals in Abhängigkeit der von dem Markierungssignal angegebenen Sequenzlänge und damit der Anstiegszeit des zu versteilernden Signals vorzunehmen. Es besteht damit die Möglichkeit, solche Signalanteile, die frequenzmäßig relativ nah an der Bandgrenze liegen, stärker zu versteilern als andere Signalanteile, die von der Bandbegrenzung kaum betroffen waren. Selbstverständlich besteht die Möglichkeit, ausschließlich solche frequenzmäßig relativ nah an der Bandgrenze liegenden Signale zu versteilern und tieferfrequente Signalanteile die Schaltungsanordnung unverändert passieren zu lassen.

Die Schaltungsanordnung ist in dieser Hinsicht an Signale vieler Anwendungsbereiche bzw. unterschiedlich bandbegrenzte Signale anpaßbar.

Nach einer weiteren Ausgestaltung der Erfindung ist vorgesehen, daß in dem Sequenzgenerator ein Komparator vorgesehen ist, welcher während der durch das verzögerte Markierungssignal angegebenen Sequenz das versteilerte Signal mit dem Anfangswert des verzögerten Digitalsignals und dem aus dem FIFO-Speicher ausgelesenen Endwert vergleicht und nur dann eine Umschaltung des Multiplexers auf das versteilerte Signal auslöst, wenn dieses einen Amplitudenwert aufweist, der zwischen dem Anfangswert und dem Endwert liegt, und daß der Multiplexer während der übrigen Zeitabschnitte der durch das Markierungssignal angegebenen Sequenz während deren erster Hälfte auf den Anfangswert und während deren zweiter Hälfte auf den Endwert geschaltet wird.

Gemäß dieser Ausgestaltung wird also während der durch das verzögerte Markierungssignal angegebenen Zeitspanne das zu versteilernde Signal nicht zwangsläufig durch das versteilerte Signal ersetzt. Es wird während dieser Zeitspanne vielmehr das versteilerte Signal mit dem Anfangswert des verzögerten Digitalsignals, den dieses zu Beginn der Sequenz aufweist, und dem aus dem FIFO-Speicher herausgelesenen Endwert des Digitalsignals verglichen. Nur dann, wenn dieser Vergleich ergibt, daß der Wert des zu versteilernden Signals zwischen dem Anfangswert und dem Endwert des Digitalsignals liegt, wird das versteilerte Signal anstelle des Originalsignals in die Sequenz eingestanzt. Liegt der Wert des versteilerten Signals dagegen nicht zwischen dem Anfangswert und dem Endwert des Digitalsignals, so schaltet der Multiplexer während dieser Zeitabschnitte nicht auf das versteilerte Signal, sondern fügt in das Signal den Anfangswert bzw. den Endwert ein. Während der ersten Hälfte der Sequenz wird dabei der Anfangswert anstelle des versteilerten Signals gewählt, wohingegen in der zweiten Hälfte der Endwert gewählt wird.

Das den Multiplexer verlassende Signal entsteht also in der Weise, daß vor Beginn der durch das verzögerte Markierungssignal angegebenen Sequenz der Multiplexer auf das verzögerte Originalsignal schaltet. Mit Beginn der Sequenz überprüft der Komparator, ob das versteilerte Signal in dem Wertebereich zwischen Anfangs- und Endwert liegt. Ist dies nicht der Fall, schaltet der Multiplexer auf den Anfangswert des Signals. Sobald das versteilerte Signal diesen Anfangswert erreicht, wird auf das versteilerte Signal geschaltet. Verläßt nun dieses versteilerte Signal bezüglich seiner Amplitudenwerte im Laufe der Sequenz den Wertebereich zwischen Anfangs- und Endwert des Signals, so wird auf den Endwert des Signals geschaltet, der ja aus dem FIFO-Speicher ausgelesen wurde. Am Ende der durch das verzögerte Markierungssignal angegebenen Sequenz schaltet der Multiplexer wieder auf das verzögerte, nicht versteilerte Signal.

Diese Anordnung weist insbesondere den Vorteil auf, daß Überschwinger des in dem Sequenzgenerator erzeugten versteilerten Signals nicht auf den Ausgang des Multiplexers und damit der Schaltungsanordnung gelangen. Die Schaltungsanordnung weist damit ideale Eigenschaften auf, da in der Sequenz zwar der ursprüngliche Verlauf einer Flanke durch eine versteilerte Flanke ersetzt wird, die bei der Erzeugung solcher versteilerten Flanken jedoch zwangsläufig auftretenden Überschwinger am Anfang und am Ende jedoch unterdrückt werden. Diese Unterdrückung der Überschwinger geschieht dadurch, daß während dieser Zeiten auf den Anfangs- bzw. Endwert geschaltet wird. Wird die Schaltungsanordnung beispielsweise zur Versteilerung eines Farbsignals eines Farbfernsehsignals eingesetzt, so ist der optische Eindruck sehr viel günstiger als bei Versteilerungen mit Überschwingern, da Überschwinger insbesondere Farbverfälschungen hervorrufen können.

Nach einer weiteren Ausgestaltung der Erfindung ist vorgesehen, daß in dem Seqeuenzgenerator durch Vergleich des aus dem FIFO-Speicher ausgelesenen Endwertes mit dem Anfangswert des verzögerten Digitalsignals ermittelt wird, in welcher Richtung die in der Sequenz enthaltene Signalflanke verläuft und daß der Sequenzgenerator laufend jeweils zwei aufeinanderfolgende Werte des in ihm generierten versteilerten Signals miteinander vergleicht und in dem versteilerten Signal den jeweils zweiten Vergleichswert durch den ersten ersetzt, sofern der zweite Wert von dem ersten Wert nicht in Richtung des Verlaufs der Signalflanke abweicht.

In praktischen Anwendungen kann es vorkommen, daß das zu versteilernde Signal mit einem Rauschsignal überlagert ist. Dies kann in ungünstigen Fällen dazu führen, daß das in dem Sequenzgenerator generierte versteilerte Signal im Bereich der zu versteilernden Flanke nicht monoton verläuft. Derartige Signalverläufe sind jedoch unerwünscht, da sie insbesondere nicht dem ursprünglichen Verlauf der Flanke entsprechen. Derartige Störungen in der generierten Flanke können dadurch unterdrückt werden, daß der Sequenzgenerator durch Vergleich des aus dem FIFO-Speicher ausgelesenen Endwerts mit dem Anfangswert des verzögerten Digitalsignals ermittelt, in welcher Richtung die in der Sequenz enthaltene Signalflanke verläuft, d.h. also, ob sie steigenden oder fallenden Verlauf hat. Darüber hinaus werden im Sequenzgenerator jeweils zwei aufeinanderfolgende Werte des in ihm generierten versteilerten Signals miteinander verglichen. Der Vergleich dieser Signale ergibt unmittelbar, ob eine Flanke entsprechend dem gewünschten Verlauf detektiert wird. Wurde zuvor durch Vergleich der Anfangs- und Endwerte festgestellt, daß die Flanke steigenden Verlauf hat, so muß der zweite Vergleichswert in jedem Falle gleich oder größer sein als der erste Vergleichswert. Umgekehrt muß bei einer fallenden Flanke der zweite Vergleichswert gleich oder kleiner als der erste sein. Sind diese Bedingungen nicht erfüllt, so wird in dem Sequenzgenerator der zweite Vergleichswert durch den ersten ersetzt, d.h. also der erste Vergleichswert gehalten. Erst, wenn die Vergleichswerte wieder in gewünschter Weise ansteigenden bzw. fallenden Verlauf der Flanke markieren, wird wieder auf die aktuellen Werte des in dem Sequenzgenerator versteilerten Signals geschaltet. Auf diese Weise sind die oben erwähnten Unstätigkeiten in dem vom Sequenzgenerator erzeugten versteilerten Signal in dem Ausgangssignal der Schaltungsanordnung nicht mehr enthalten.

Anstelle der Generierung des versteilerten Signals mittels Aufaddition der zweiten Ableitung ist nach einer Ausgestaltung der Erfindung vorgesehen, daß in dem FIFO-Speicher zum Zeitpunkt des Endes der nicht verzögerten Sequenz auch ein Informationssignal eingelesen wird, welches die Dauer der Sequenz angibt, daß in dem Sequenzgenerator das versteilerte Signal mittels wenigstens eines Zählers in der Weise generiert wird, daß der Zähler zu Beginn der Sequenz mit Hilfe des aus dem FIFO-Speicher ausgelesenen Informationssignals auf einen geeigneten Anfangswert gesetzt wird, daß der Zähler während der Sequenz mit jedem neuen Abtastwert abwärtszählt, daß verschiedene Zählerstände dekodiert werden und daß zu den Dekodierungszeitpunkten mittels einer Arithmetik-Einheit geeignet gewichtete Differenzen des Anfangswertes und des Endwertes des zu versteilernden Signals erzeugt werden, die das versteilerte Signal darstellen.

Bei dieser Ausführungsform des Sequenzgenerators wird mit Hilfe des Zählers und der verschieden gewichteten Differenzen des Anfangswertes und des Endwertes eine künstliche Signalflanke erzeugt. Dazu ist es erforderlich, daß zu Beginn der verzögerten Sequenz nicht nur der Anfangs- und der Endwert des zu versteilernden Signals bekannt sind, sondern auch die Länge der Sequenz. Dazu wird diese Sequenzlänge, die beispielsweise mittels des Flankendetektors festgestellt werden kann, ebenso wie der Endwert des Digitalsignals in den FIFO-Speicher eingelesen. Dieses Signal wird zu Beginn der verzögerten Sequenz ebenso wie der Endwert ausgelesen und dient dazu, zu Beginn der Sequenz in Abhängigkeit von deren Länge, einen Zähler in dem Sequenzgenerator zu setzen. Während der Dauer der Sequenz zählt dieser Zähler abwärts, beispielsweise mit jedem neuen Abtastwert des zu versteilernden Digitalsignals. Die Zählerstände dieses Zählers werden ausdekodiert, so daß also zu bestimmten Zeitpunkten, deren Lage in der Sequenz bekannt ist, bestimmte Dekodierungssignale vorliegen. Diese werden nun dazu eingesetzt, verschieden gewichtete Differenzen des Anfangswertes und des Endwertes zu erzeugen, die den versteilerten Signalverlauf bilden. Diese Differenzen werden zu Beginn der Sequenz so ausgelegt sein, daß der Anfangswert dominiert, während zu Ende der Sequenz der Endwert dominiert. Je nach Aufwand kann eine sehr feine Stufung zwischen diesen Werten vorgenommen werden. In dieser Ausführungsform des Sequenzgenerators wird also während der detektierten Sequenz, die durch das Markierungssignal angegeben wird, eine künstliche Flanke erzeugt und in das Originalsignal eingefügt. Auch bei Erzeugung dieser künstlichen Sequenz ist aber eine Anpassung an die Anfangs- und Endwerte und insbesondere auch an die Anstiegszeit bzw. an deren Länge gegeben.

Nach weiteren Ausgestaltungen der Erfindung ist vorgesehen, daß in dem Flankendetektor die erste Ableitung des zu versteilernden Signals gebildet wird, das der Betrag der ersten Ableitung bestimmt und mit einem Schwellwert verglichen wird und daß der Flankendetektor das Markierungssignal während derjenigen Zeiten generiert, in denen der Betrag der ersten Ableitung den Schwellwert überschreitet und daß die Höhe des Schwellwertes laufend in Abhängigkeit der Höhe der Amplitudenänderungen des zu versteilernden Signals verändert wird.

Auf diese Weise findet quasi eine laufende Anpassung der Flankendetektion an die Höhe der zu versteilernden Signalflanken des Signals statt.

Anhand der Zeichnung werden zwei Ausführungsbeispiele der Erfindung näher erläutert. Es zeigen:
Fig. 1 ein Blockschaltbild einer ersten Ausführungsform der Schaltungsanordnung mit einem Sequenzgenerator, in welchem das versteilerte Signal mittels Bildung der zweiten Ableitung generiert wird,
Fig. 2 zeitliche Signalverläufe der Schaltungsanordnung gemäß Fig. 1,
Fig. 3 ein Blockschaltbild einer zweiten Ausführungsform der Schaltungsanordnung, bei der der Sequenzgenerator unter anderem einen Zähler und eine Arithmetik-Einheit aufweist und
Fig. 4 einige zeitliche Signalverläufe der Schaltungsanordnung gemäß Fig. 3.

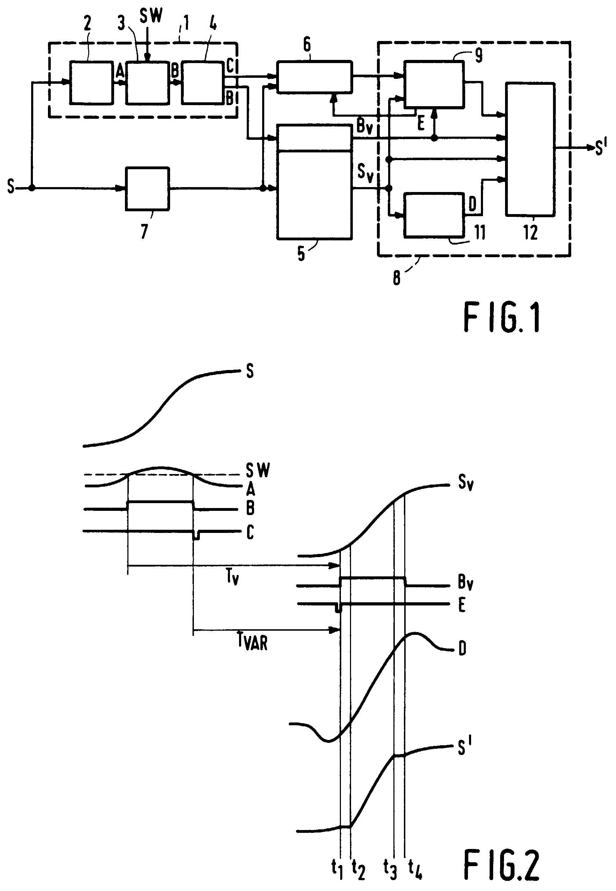

Eine in Fig. 1 im Blockschaltbild dargestellte erste Ausführungsform einer Schaltungsanordnung zur Versteilerung von digitalen Signalen, dient zur Versteilerung eines Farbsignals eines Farbfernsehsignals. Dieses Farbsignal S liegt als digitales Signal als Folge amplitudendiskreter n-bit breiter, binär codierter Abtastwerte eines Analogsignals vor.

Dieses digitale Farbsignal S wird in der Schaltungsanordnung gemäß Fig. 1 zunächst einem Flankendetektor 1 zugeführt. Innerhalb des Flankendetektors 1 gelangt das Signal zunächst zu einem Detektionsfilter 2, in welchem die erste Ableitung des Digitalsignals S gebildet wird und in dem anschließend die Betragsbildung dieser ersten Ableitung vorgenommen wird. Nach Betragsbildung wird diese erste Ableitung einem in dem Flankendetektor 1 vorgesehenen Komparator 3 zugeführt. Dem Komparator 3 ist außerdem ein Schwellwertsignal SW zugeführt, dessen Generierung in der Fig. 1 nicht näher dargestellt ist. In dem Komparator 3 wird ein Vergleich des Betrages der ersten Ableitung mit diesem Schwellwert SW vorgenommen. Während der Zeiten, in denen der Betrag der ersten Ableitung den Schwellwert SW überschreitet, generiert der Komparator 3 ein Markierungssignal, das einem Signalgenerator 4 in dem Flankendetektor 1 zugeführt wird. Dieser Signalgenerator 4 leitet das Markierungssignal an eine Verzögerungsvorrichtung 5 weiter und generiert außerdem einen Signalimpuls, welcher mit dem Ende des Markierungssignals zusammenfällt. Dieser Markierungsimpuls ist einem FIFO-Speicher 6 zugeführt. Bei dem FIFO-Speicher 6 handelt es sich um einen Speicher, in den in serieller Form Daten eingelesen werden können, welche in gleicher Reihenfolge seriell wieder auslesbar sind.

Das digitale Farbsignal S ist außerdem einem Verzögerungsglied 7 zugeführt, welches dazu dient, das Digitalsignal S um den gleichen Wert zu verzögern, um den das Markierungssignal im Flankendetektor 1 verzögert generiert wird. Sowohl dieses mittels des Verzögerungsgliedes 7 verzögerte digitale, zu versteilernde Signal S, wie auch das den Flankendetektor 1 verlassende Markierungssignal sind der Verzögerungsvorrichtung 5 zugeführt. In dieser Verzögerungsvorrichtung 5 werden beide Signale um eine feste Zeitdauer verzögert. Die Länge dieser Zeitdauer richtet sich nach der maximalen Länge der zu versteilernden Sequenzen.

Das Ausgangssignal des Verzögerungsgliedes 7 ist außerdem dem FIFO-Speicher 6 zugeführt. Das von dem Signalgenerator 4 in dem Flankendetektor 1 generierte Signal am Ende des Markierungssignals dient dazu, in den FIFO-Speicher 6 den aktuellen Wert des mittels des Verzögerungsgliedes 7 verzögerten digitalen Farbsignals S einzulesen. Somit wird in dem FIFO-Speicher 6 zu Ende der Sequenz der aktuelle Amplitudenwert des digitalen Farbsignals S abgespeichert.

In der Schaltungsanordnung gemäß Fig. 1 ist ferner ein Sequenzgenerator 8 vorgesehen. Dieser Sequenzgenerator 8 weist eine Steuerung 9 auf, in der Anfangswert und Richtung der Flanke in der Sequenz bestimmt werden, sowie ein Versteilerungsfilter 11 und einen Komparator und Multiplexer 12. Diese Elemente des Sequenzgenerators sind wie folgt verschaltet:

Der Steuerung 9 werden das Ausgangssignal des FIFO-Speichers 6 sowie das von der Verzögerungsvorrichtung 5 gelieferte, verzögerte Markierungssignal zugeführt. Die Steuerung 9 generiert aus dem verzögerten Markierungssignal einen Impuls, welcher den Beginn der verzögerten Sequenz markiert. Dies Signal dient dazu, aus dem FIFO-Speicher 6 den dort zuvor eingelesenen Endwert des Signals auszulesen. Die Steuerung 9 ermittelt ferner zu Beginn der verzögerten Sequenz die Amplitude des verzögerten, von der Verzögerungsvorrichtung 5 gelieferten digitalen Signals S_{V}, das zu diesem Zwecke der Steuerung 9 ebenfalls zugeführt ist. Aus den auf diese Weise bekannten Anfangswert und dem Endwert des Digitalsignals bestimmt der Schaltungsblock 9 die Richtung des Flankenverlaufs, d.h. also ob die Flanke steigenden oder fallenden Verlauf hat. Diese drei Informationen werden dem Komparator und Multiplexer 12 zugeführt. Dem Komparator und Multiplexer 12 sind ferner die von der Verzögerungsvorrichtung gelieferten verzögerten Signale, nämlich das verzögerte Markierungssignal und das verzögerte, zu versteilernde Digitalsignal zugeführt. Letzteres ist außerdem dem Versteilerungsfilter 11 zugeführt, in dem die zweite Ableitung des Signals gebildet wird und zu dem ursprünglichen Signal aufaddiert wird. Dieses so gewonnene versteilerte Signal ist ebenfalls dem Komparator und Multiplexer 12 zugeführt.

Die Arbeitsweise der in Fig. 1 im Blockschaltbild dargestellten Schaltungsanordnung wird im folgenden anhand einiger in Fig. 2 dargestellter zeitlicher Signalverläufe näher erläutert.

In Fig. 2 ist eine ansteigende Flanke des digitalen Farbsignals S in quasi analoger Form dargestellt. Tatsächlich handelt es sich bei dem digitalen Farbsignal S um einzelne, zeitdiskret vorliegende Abtastwerte, welche jeweils mehrere Bit Breite aufweisen. In der Darstellung gemäß Fig. 2 ist dieses Signal nur zur Verdeutlichung in quasi analoger Form dargestellt.

Dieses digitale Farbsignal S wird in der Schaltungsanordnung gemäß Fig. 1 dem Detektionsfilter 2 zugeführt, in dem die erste Ableitung gebildet wird, von der anschließend der Betrag gebildet wird. Dieses Signal A, das also den Betrag der ersten Ableitung des digitalen Signals S darstellt, ist in Fig. 2 ebenfalls dargestellt. In dem Komparator 3 der Anordnung gemäß Fig. 1 wird dieses Signal mit einem Schwellwert SW verglichen. Der Komparator 3 generiert während derjenigen Zeiten, in denen das Signal S den Schwellwert SW überschreitet, ein Markierungssignal B, welches ebenfalls in Fig. 2 dargestellt ist. Dieses Markierungssignal B markiert also die zeitliche Lage der Sequenz, in der sich die zu versteilernde Flanke des digitalen Farbsignals S befindet. Der Signalgenerator 4 des Flankendetektors 1 generiert zum Zeitpunkt des Endes des Markierungssignals B einen Impuls C, der in Fig. 2 dargestellt ist und welcher dazu dient, zu diesem Zeitpunkt in den FIFO-Speicher 6 den aktuellen Amplitudenwert des digitalen Farbsignals S einzulesen. Somit handelt es sich bei diesem Amplitudenwert um denjenigen Wert, den das digitale Farbsignal S zum Zeitpunkt des Endes der detektierten Sequenz annimmt.

In der Verzögerungsvorrichtung 5 gemäß Fig. 1 werden sowohl das in diskreten Abtastwerten vorliegende digitale Farbsignal S wie auch das von dem Flankendetektor 1 gelieferte Markierungssignal B um eine feste Zeitspanne verzögert, die in der Fig. 2 mit T_{V} bezeichnet ist. Nach dieser festen Zeitspanne werden der Verzögerungsvorrichtung 5 gemäß Fig. 1 die in Fig. 2 dargestellten verzögerten Signale S_{V} und B_{V} entnommen, die das verzögerte Digitalsignal S bzw. das verzögerte Markierungssignal B darstellen.

Diese beiden Signale S_{V} und B_{V} sind der Steuerung 9 in dem Sequenzgenerator 8 zugeführt. Dort wird zu Beginn der Sequenz, d.h. also mit Beginn des verzögerten Markierungssignales B_{V} der aktuelle Abtastwert des Signales S_{V} festgestellt und festgehalten. Ferner wird zu diesem Zeitpunkt ein Impuls eines Signales E, das ebenfalls in Fig. 2 dargestellt ist, generiert. Dieses Signal E dient dazu, zum Zeitpunkt des Beginns der verzögerten Sequenz den in dem FIFO abgespeicherten Endwert des Digitalsignals auszulesen. Der Endwert wurde in dem FIFO also für eine in der Fig. 2 mit T_{VAR} bezeichnete Zeitspanne abgespeichert, deren Länge je nach Länge der detektierten Sequenz variiert. Somit stehen der Steuerung 9 in dem Sequenzgenerator 8 zu Beginn der verzögerten Sequenz sowohl der aktuelle Anfangswert des verzögerten Digitalsignals, wie auch der Endwert fest, den das Digitalsignal am Ende der verzögerten Sequenz annehmen wird. Aus diesen beiden Werten bestimmt die Steuerung 9 den Richtungsverlauf der Flanke, die in dem in Fig. 2 dargestellten Beispiel steigenden Verlauf hat. Diese drei Werte, d.h. also der Anfangswert des Digitalsignals, der Endwert des Digitalsignals und der Richtungsverlauf der Flanke sind dem Komparator und Multiplexer 12 in der Schaltungsanordnung gemäß Fig. 1 zugeführt. Dem Multiplexer 12 werden darüber hinaus das verzögerte digitale Signal S_{V} und das verzögerte Markierungssignal B_{V} zugeführt. Letzteres ist auch dem Versteilerungsfilter 11 in dem Sequenzgenerator 8 zugeführt, welche die zweite Ableitung dieses Signales bildet und auf das verzögerte Signal aufaddiert. Somit liefert das Versteilerungsfilter 11 an seinem Ausgang ein versteilertes Signal D, welches in Fig. 2 dargestellt ist. Dieses Signal wird ebenfalls dem Komparator und Multiplexer 12 zugeführt.

Der Komparator und Multiplexer 12 liefert an seinem Ausgang bis zu demjenigen Zeitpunkt, in dem das Markierungssignal B_{V} auftritt, das verzögerte Digitalsignal, wie es von der Verzögerungsvorrichtung 5 geliefert wird. Das Ausgangssignal S' des Komparators und Multiplexers 12 folgt also bis zu diesem Zeitpunkt, der in der Fig. 2 als t1 bezeichnet ist, dem verzögerten Originalsignal S_{V}. Zum Zeitpunkt t1 tritt nun das Markierungssignal auf, so daß der Komparator und Multiplexer 12 zunächst einen Vergleich des versteilerten Signalverlaufs D mit dem ihm von der Steuerung 9 gelieferten Anfangs- und Endwert des Digitalsignals vornimmt. Da in dem in der Fig. 2 dargestellten Beispiel zum Zeitpunkt t1 der Amplitudenwert des versteilerten Signals D nicht in dem Amplitudenbereich zwischen Anfangs- und Endwert des Signales S_{V} zu den Zeitpunkten t1 bzw. t4 liegt, schaltet der Komparator und Multiplexer 12 auf den Anfangswert des Digitalsignals. Dieser Wert wird bis zum Zeitpunkt t2 gehalten. Ab dem Zeitpunkt t2 liegt der Amplitudenwert des versteilerten Signals D zwischen den Anfangswerten und den Endwert des Digitalsignals S_{V}. Dieses gilt bis zum Zeitpunkt t3. Während dieser Zeitspanne liefert der Komparator und Multiplexer 12 an seinem Ausgang das versteilerte Signal D, wie es ihm von der Versteilerungsvorrichtung 11 innerhalb des Sequenzgenerators 8 zugeführt wird. Ab dem Zeitpunkt t3 liegt jedoch der aktuelle Amplitudenwert des versteilerten Signals D nicht mehr zwischen dem Anfangs- und Endwert des Digitalsignales S. Daher schaltet der Komparator und Multiplexer 12 auf den ihm von dem Schaltungsblock 9 gelieferten Endwert des Digitalsignals S. Dieses gilt bis zum Zeitpunkt t4, da während dieser gesamten Spanne der aktuelle Abtastwert des versteilerten Signales D außerhalb des Wertebereichs zwischen Anfangs- und Endwert des Digitalsignals S liegt. Zum Zeitpunkt t4 ist das Ende der Sequenz erreicht, was durch das verzögerte Markierungssignal B_{V} markiert wird. Daher schaltet der Komparator 12 zu diesem Zeitpunkt wieder auf das verzögerte Digitalsignal S_{V}.

Im Ergebnis stellt das Ausgangssignal S' des Komparators und Multiplexers 12, das gleichzeitig das Ausgangssignal der gesamten Schaltungsanordnung darstellt, einen versteilerten Verlauf der ursprünglich in dem Digitalsignal S enthaltenen Flanke dar. Es ist noch zu erwähnen, daß in der Fig. 2 der Zeitabschnitt t2 bis t3 zwecks Verdeutlichung der Abläufe relativ breit dargestellt wurde. Tatsächlich wird dieser Abschnitt im Verhältnis zu der Gesamtzeitspanne t1 bis t4 kleiner sein, um eine möglichst große Versteilerung zu erzielen. Das versteilerte Signal S' orientiert sich an dem ursprünglichen Verlauf des Signales S. Sollte das Signal S beispielsweise eine kürzere oder längere Flanke aufweisen, so würde das Ausgangssignal S' in entsprechender Weise angepaßt. Ein besonderer Vorteil der Schaltungsanordnung besteht darin, daß das Ausgangssignal S' keinerlei Überschwinger aufweist, welche insbesondere bei Farbsignalen störende Farbsäume hervorrufen.

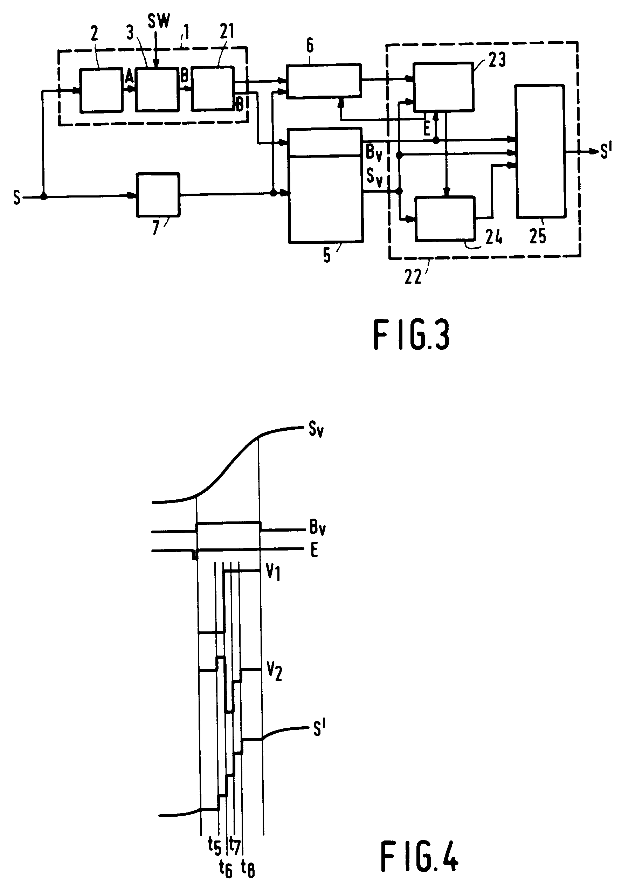

In Fig. 3 ist eine zweite Ausführungsform der Schaltungsanordnung im Blockschaltbild dargestellt, welche ebenfalls einen Flankendetektor 1, eine Verzögerungsvorrichtung 5, einen FIFO-Speicher 6 sowie ein Verzögerungsglied 7 aufweist. Das Verzögerungsglied 7 und die Verzögerungsvorrichtung 5 arbeiten in der gleichen Weise wie die entsprechenden Elemente der Schaltungsanordnung gemäß Fig. 1. In dem Flankendetektor 1 sind das Detektionsfilter 2 und der Komparator 3 ebenfalls identisch mit den entsprechenden Elementen der Schaltungsanordnung gemäß Fig. 1. In der Schaltungsanordnung gemäß Fig. 3 ist in dem Flankendetektor 1 ein Signalgenerator 21 vorgesehen, welcher ebenso wie der Signalgenerator 4 der Schaltungsanordnung gemäß Fig. 1 einen Markierungsimpuls am Ende der detektierten Sequenz generiert. Der Signalgenerator 11 gemäß Fig. 3 generiert darüber hinaus jedoch ein Signal, welches die Länge der markierten Sequenz angibt. Dieses Signal wird zum Zeitpunkt des Endes der Sequenz gemeinsam mit dem aktuellen Abtastwert in den FIFO-Speicher 6 eingelesen.

Die Schaltungsanordnung gemäß Fig. 3 weist einen Sequenzgenerator 22 auf, welcher in anderer Weise aufgebaut ist als der Sequenzgenerator 8 der Schaltungsanordnung gemäß Fig. 1. Der Sequenzgenerator 22 gemäß Fig. 3 weist eine Steuerung 23 auf, in der u.a. ein Zähler und ein Dekoder enthalten sind, welche beide in der Figur nicht näher dargestellt sind. Diese Steuerung 23 bestimmt, ebenso wie die Steuerung 9 der Schaltungsanordnung gemäß Fig. 1, zum Zeitpunkt des Beginns der verzögerten Sequenz, wie sie von der Verzögerungsvorrichtung 5 geliefert wird, den Amplitudenwert des verzögerten Digitalsignals S_{V}. Außerdem wird zu Beginn der Sequenz aus dem FIFO-Speicher 6 der Endwert des Digitalsignals sowie der von dem Impulsgenerator 21 gelieferte Längenwert der Sequenz ausgelesen. In der Steuerung 23 stehen also der Anfangswert des Digitalsignals S_{V}, dessen Endwert, sowie die Länge der Sequenz als entsprechende Daten zur Verfügung. In Abhängigkeit dieser Werte wird ein in der Steuerung 23 vorgesehener Zähler gesetzt, welcher mit jedem neuen Abtastwert des verzögerten Digitalsignals S_{V} abwärtszählt. Es ist ferner ein Dekoder vorgesehen, welcher verschiedene Zählerstände ausdekodiert und entsprechende Signale an eine Arithmetik-Einheit 24, welche ebenfalls Bestandteil des Sequenzgenerators 22 ist, liefert. Ferner liefert die Steuerung 23 den Anfangswert und den Endwert des Digitalsignals zu Anfang und zu Ende der Sequenz. In der Arithmetik-Einheit 24 werden nun verschieden gewichtete Differenzen dieser beiden Werte gebildet. Diese verschieden gewichtete Differenzen werden je nach ausdekodiertem Zeitpunkt an einen ebenfalls in dem Sequenzgenerator 22 vorgesehenen Multiplexer 25 geliefert.

Der Multiplexer 25 stellt an seinem Ausgang das versteilerte Signal S' zur Verfügung. Während derjenigen Zeiten, in denen kein Markierungssignal B_{V} auftritt, liefert der Multiplexer 25 als Ausgangssignal das von der Verzögerungsvorrichtung 5 gelieferte verzögerte Digitalsignal S_{V}. Während einer durch das Markierungssignal B_{V} markierten Sequenz schaltet der Multiplexer 25 um auf die von der Arithmetik-Einheit 24 gelieferten Werte. Während einer solchen markierten Sequenz wird also von dem verzögerten Originalsignal S_{V} auf die von der Arithmetik-Einheit 24 gelieferten Werte umgeschaltet. Auf diese Weise wird während dieser Zeitspanne eine Sequenz in das Signal quasi eingestanzt.

In Fig. 4 ist wiederum, entsprechend der Darstellung gemäß Fig. 2, eine ansteigende Flanke eines digitalen Farbsignals S in quasi analoger Form dargestellt. Die weiteren, in Fig. 4 dargestellten Signalverläufe treten in der Schaltungsanordnung gemäß Fig. 3 auf.

Da sich die Schaltungsanordnung gemäß Fig. 3 bezüglich der Generierung des Markierungssignals, bezüglich des FIFO-Speichers 6 und der Verzögerungsvorrichtung 5 von der Schaltungsanordnung gemäß Fig. 1 nicht unterscheidet, sind die diesbezüglichen Signale mit den in der Schaltungsanordnung gemäß Fig. 1 auftretenden entsprechenden Signalen identisch. In der Fig. 4 ist das verzögerte Signal S_{V}, das die verzögerte Sequenz des zu versteilernden Signals darstellt, dargestellt. Ferner ist das Markierungssignal B_{V} dargestellt, das die entsprechende Sequenz markiert.

In der Steuerung 23 gemäß Fig. 3 wird in entsprechender Weise wie in der Steuerung 9 gemäß Fig. 1 ein Signal erzeugt, das in der Fig. 4 mit E bezeichnet ist, und das den Beginn der von dem Markierungssignal B_{V} markierten Sequenz angibt. Dieses Signal dient dazu, das Auslesen der in dem FIFO-Speicher 6 abgespeicherten Werte auszulösen.

In der Darstellung gemäß Fig. 4 sind ferner zwei Signale V₁ und V₂ sowie ein Signal S' dargestellt, daß das Ausgangssignal des Multiplexers 25 gemäß Fig. 3 darstellt und das den versteilerten Signalverlauf repräsentiert.

Die beiden Signale V₁ und V₂ treten innerhalb der Arithmetik-Einheit 24 der Schaltungsanordnung gemäß Fig. 3 auf.

Wie bereits erwähnt wurde, ist in der Steuerung 23 ein Zähler vorgesehen, welcher auf einen geeigneten Anfangswert gesetzt wurde, und der mit jedem neuen Abtastwert des verzögerten Digitalsignals S_{V} abwärtszählt. Es werden bestimmte Zählerstände ausdekodiert und zu dem entsprechenden Zeitpunkt ein entsprechendes Signal an die Arithmetik-Einheit 24 gegeben. In dem in der Fig. 4 dargestellten Beispielsfalle sind die ausdekodierten Zeitpunkte mit t5, t6, t7 und t8 markiert. Zu diesen Zeitpunkten gibt also die Steuerung 23 entsprechende Signale an die Arithmetik-Einheit 24. In der Arithmetik-Einheit 24 werden nun in den zwischen diesen Zeitpunkten liegenden Zeitabschnitten geeignet gewichtete Differenzen zwischen dem Anfangswert und dem Endwert des Digitalsignals zu Anfang bzw. zu Ende der Sequenz erzeugt. Diese gewichteten Differenzen können auf verschiedene Weise generiert werden. In dem in Fig. 4 angedeuteten Beispielsfall wird so vorgegangen, daß zwei Signale V₁ und V₂ überlagert werden. Das Signal V₁ wird in der Weise generiert, daß es von Beginn der Sequenz bis zum Zeitpunkt t6 den Anfangswert des zu versteilernden Digitalsignals und vom Zeitpunkt t6 bis zum Ende der Sequenz dessen Endwert annimmt. Ein in der Arithmetik-Einheit 24 generiertes Signal V₂ hat in den Zeitabschnitten von Beginn der Sequenz bis zum Zeitpunkt t5 und in dem Zeitabschnitt t8 bis zum Ende der Sequenz den Wert Null. In dem Zeitabschnitt t5 bis t6 wird in dem in der Fig. 4 dargestellten Beispielsfall ein positives Signal erzeugt, in dem Zeitabschnitt t6 bis t7 ein negatives Signal mit deutlich größerer Amplitude und in dem Zeitabschnitt t7 bis t8 ein negatives Signal geringerer Amplitude. Die Signale V₁ und V₂ werden in in der Fig. 3 nicht dargestellter Weise überlagert.

Dieses überlagerte Signal ist in dem in der Fig. 4 dargestellten Signal S', wie es am Ausgang des Multiplexers 25 vorliegt, während des Zeitraumes t5 bis t8 enthalten. In der Zeitspanne von Beginn der in der Fig. 4 dargestellten Sequenz bis zum Zeitpunkt t5 sowie in der Zeitspanne t8 bis zum Ende der Sequenz nimmt das Signal S' dagegen den Anfangswert bzw. den Endwert des zu versteilernden Signals an, wie dies oben bereits für das erste Ausführungsbeispiel beschrieben wurde.

In dem in der Fig. 4 dargestellten Beispielsfalle mit Signalen, wie sie in der Anordnung gemäß Fig. 3 auftreten, wurde also die zu versteilernde Sequenz S bzw. S_{V} recht deutlich versteilert, so daß der Signalübergang bzw. die Signalflanke nur noch in dem recht engen Zeitbereich t5 bis t8 auftritt.

## Patentansprüche

1. Schaltungsanordnung zum Versteilern von Signalflanken eines als Folge amplitudendiskreter Abtastwerte eines Analogsignals vorliegenden Digitalsignals (S), dadurch gekennzeichnet, daß das zu versteilernde Digitalsignal einem Flankendetektor (1) zugeführt wird, welcher während der Zeitspanne, in der eine Flanke des Digitalsignals einen vorgebbaren Steilheitswert (SW) überschreitet, ein Markierungssignal (B) abgibt, das die der zu versteilernden Flanke des Digitalsignals entsprechende Sequenz der Abtastwerte im Digitalsignal markiert, daß eine Verzögerungseinrichtung (5) vorgesehen ist, in welcher das Digitalsignal und das Markierungssignal um eine feste Zeitspanne (Tᵥ) verzögert werden, deren Dauer länger ist als die maximale Zeitdauer der markierten Sequenzen, daß ein FIFO-Speicher (6) vorgesehen ist, in den der Abtastwert des nicht verzögerten Digitalsignals zum Zeitpunkt des Endes der nicht verzögerten, markierten Sequenz eingelesen und zum Zeitpunkt des Beginns der verzögerten markierten Sequenz wieder ausgelesen wird, und daß ein Sequenzgenerator (8, 22) vorgesehen ist welcher unter Heranziehung des verzögerten Digitalsignals (Sᵥ), des verzögerten Markierungssignals (Bᵥ) und des aus dem FIFO-Speicher (6) ausgelesenen Wertes ein versteilertes Signal (S') generiert und mit Hilfe eines Multiplexers (12) in wenigstens einen Teilabschnitt der markierten Sequenz des verzögerten Digitalsignals anstelle der ursprünglichen Sequenz des Signals einsetzt.

2. Schaltungsanordnung nach Anspruch 1,
dadurch gekennzeichnet, daß in dem Sequenzgenerator (8) das versteilerte Signal mittels Addition des verzögerten Digitalsignals mit dessen zweiter Ableitung generiert wird.

3. Schaltungsanordnung nach Anspruch 2,
dadurch gekennzeichnet, daß bei der Addition eine Gewichtung der beiden Signalanteile in Abhängigkeit des Maßes der gewünschten Flankenversteilerung vorgenommen wird.

4. Schaltungsanordnung nach Anspruch 3,
dadurch gekennzeichnet, daß die Gewichtung in Abhängigkeit der von dem Markierungssignal angegebenen Sequenzlänge in der Weise vorgenommen wird, daß für kürzere Sequenzlängen stärkere Versteilerungen und für längere Sequenzlängen geringere Versteilerungen vorgenommen werden.

5. Schaltungsanordnung nach einem der Ansprüche 1 bis 4,
dadurch gekennzeichnet, daß in dem Sequenzgenerator (8) ein Komparator (12) vorgesehen ist, welcher während der durch das verzögerte Markierungssignal angegebenen Sequenz das versteilerte Signal mit dem Anfangswert des verzögerten Digitalsignals und dem aus dem FIFO-Speicher ausgelesenen Endwert vergleicht und nur dann eine Umschaltung des Multiplexers (12) auf das versteilerte Signal auslöst, wenn dieses einen Amplitudenwert aufweist, der zwischen dem Anfangswert und dem Endwert liegt, und daß der Multiplexer (12) während der übrigen Zeitabschnitte der durch das Markierungssignal angegebenen Sequenz während deren erster Hälfte auf den Anfangswert und während deren zweiter Hälfte auf den Endwert geschaltet wird.

6. Schaltungsanordnung nach Anspruch 5,
dadurch gekennzeichnet, daß in dem Sequenzgenerator (8) durch Vergleich des aus dem FIFO-Speicher (6) ausgelesenen Endwertes mit dem Anfangswert des verzögerten Digitalsignals ermittelt wird, in welcher Richtung die in der Sequenz enthaltene Signalflanke verläuft und daß der Sequenzgenerator (8) laufend jeweils zwei aufeinanderfolgende Werte des in ihm generierten versteilerten Signals miteinander vergleicht und in dem versteilerten Signal den jeweils zweiten Vergleichswert durch den ersten ersetzt, sofern der zweite Wert von dem ersten Wert nicht in Richtung des Verlaufs der Signalflanke abweicht.

7. Schaltungsanordnung nach Anspruch 1,
dadurch gekennzeichnet, daß in den FIFO-Speicher (6) zum Zeitpunkt des Endes der nicht verzögerten Sequenz auch ein Informationssignal eingelesen wird, welches die Dauer der Sequenz angibt, daß in dem Sequenzgenerator (22) das versteilerte Signal mittels wenigstens eines Zählers (23) in der Weise generiert wird, daß der Zähler zu Beginn der Sequenz mit Hilfe des aus dem FIFO-Speicher ausgelesenen Informationssignals auf einen geeigneten Anfangswert gesetzt wird, daß der Zähler (23) während der Sequenz mit jedem neuen Abtastwert weiterzählt, daß verschiedene Zählerstände dekodiert werden und daß zu den Dekodierungszeitpunkten mittels einer Arithmetik-Einheit (24) geeignet gewichtete Differenzen des Anfangswertes und des Endwertes des zu versteilernden Signals erzeugt werden, die das versteilerte Signal darstellen.

8. Schaltungsanordnung nach einem der Ansprüche 1 bis 7,
dadurch gekennzeichnet, daß in dem Flankendetektor (1) die erste Ableitung des zu versteilernden Signals gebildet wird, das der Betrag der ersten Ableitung bestimmt und mit einem Schwellwert verglichen wird und daß der Flankendetektor das Markierungssignal während derjenigen Zeiten generiert, in denen der Betrag der ersten Ableitung den Schwellwert überschreitet.

9. Schaltungsanordnung nach Anspruch 8,
dadurch gekennzeichnet, daß die Höhe des Schwellwertes laufend in Abhängigkeit der Höhe der Amplitudenänderungen in dem zu versteilernden Signal verändert wird.

## Claims

1. A circuit arrangement for steepening signal slopes of a digital signal (S) in the form of a sequence of amplitude-discrete sampling values of an analog signal, characterized in that the digital signal to be steepened is applied to a slope detector (1) which supplies a marking signal (B) during the period in which a slope of the digital signal exceeds a predeterminable steepness value (SW), which marking signal marks the sequence corresponding to the slope of the digital signal to be steepened of the sampling values in the digital signal, in that a delay circuit (5) is provided in which the digital signal and the marking signal are delayed by a fixed period of time (Tᵥ) whose duration is longer than the maximum period of the marked sequences, in that a FIFO memory (6) is provided into which the sampling value of the non-delayed digital signal is entered at the instant of the end of the non-delayed, marked sequence and from which memory said value is read at the instant of the start of the delayed, marked sequence, and in that a sequence generator (8, 22) is provided which generates a steepened signal (S') while taking account of the delayed digital signal (Sᵥ), the delayed marking signal (Bᵥ) and the value read from the FIFO memory (6) and substitutes it for the original sequence of the signal by means of a multiplexer (12) in at least a part of the marked sequence of the delayed digital signal.

2. A circuit arrangement as claimed in Claim 1, characterized in that the steepened signal is generated in the sequence generator (8) by adding the delayed digital signal to its second derivative.

3. A circuit arrangement as claimed in Claim 2, characterized in that during the addition, the two signal portions are weighted in dependence upon the extent of the desired steepness of the slope.

4. A circuit arrangement as claimed in Claim 3, characterized in that the weighting in dependence upon the sequence length indicated by the marking signal is performed in such a way that steeper slopes are formed for shorter sequence lengths and more gradual slopes are formed for longer sequence lengths.

5. A circuit arrangement as claimed in any one of Claims 1 to 4, characterized in that the sequence generator (8) includes a comparator (12) which compares the steepened signal with the initial value of the delayed digital signal and with the final value read from the FIFO memory during the sequence indicated by the delayed marking signal and only causes the multiplexer (12) to change over to the steepened signal when this signal has an amplitude value between the initial value and the final value, and in that during the other parts of the sequence indicated by the marking signal, the multiplexer (12) changes over to the initial value during the first half of this sequence and to the final value during its second half.

6. A circuit arrangement as claimed in Claim 5, characterized in that the sequence generator (8) determines which direction the signal slope within the sequence will take by comparing the final value read from the FIFO memory (6) with the initial value of the delayed digital signal, and in that the sequence generator (8) continuously compares two consecutive values of the steepened signal generated therein and each time replaces the second comparison value in the steepened signal by the first value in so far as the second value does not deviate from the first value as regards the direction of the signal slope.

7. A circuit arrangement as claimed in Claim 1, characterized in that an information signal is entered into the FIFO memory (6) at the instant of the end of the non-delayed sequence, said information signal indicating the duration of the sequence, in that the sequence generator (22) generates the steepened signal by means of at least a counter (23) which is set to a suitable initial value at the start of the sequence by means of the information signal read from the FIFO memory, in that the counter (23) continues to count with each new sampling value during the sequence, in that various counts are decoded and in that suitably weighted differences of the initial value and the final value of the signal to be steepened are generated by means of an arithmetic unit (24) at the decoding instants, said differences representing the steepened signal.

8. A circuit arrangement as claimed in any one of Claim 1 to 7, characterized in that the first derivative of the signal to be steepened is formed in the slope detector (1), which signal determines the value of the first derivative and is compared with a threshold value, and in that the slope detector generates the marking signal during those periods in which the value of the first derivative exceeds the threshold value.

9. A circuit arrangement as claimed in Claim 8, characterized in that the level of the threshold value is continuously varied in dependence upon the level of the amplitude variations in the signal to be steepened.

## Revendications

1. Agencement de circuit pour raidir les flancs de signal d'un signal numérique présent à la suite de valeurs de balayage d'un signal analogique, discrètes quant à leur amplitude, caractérisé en ce que le signal numérique à raidir est amené à un détecteur de flancs (1) qui, pendant le laps de temps au cours duquel un flanc du signal numérique dépasse une valeur de pente prévisible (SW), émet un signal de marquage (B) qui marque la séquence des valeurs de balayage dans le signal numérique correspondant au flanc à raidir du signal numérique, en ce qu'il est prévu un dispositif retardateur (5), dans lequel le signal numérique et le signal de marquage sont retardés d'une période déterminée (Tᵥ) dont la durée est supérieure à la durée maximale des séquences marquées, en ce qu'il est prévu une mémoire FIFO (6) dans laquelle la valeur de balayage du signal numérique non retardé au moment de la fin de la séquence marquée non retardée est sauvée et est à nouveau lue au moment du début de la séquence marquée retardée et en ce qu'il est prévu un générateur de séquences (8, 22) qui génère un signal raidi (S') en utilisant le signal numérique retardé (Sᵥ), le signal de marquage retardé (Bᵥ) et la valeur lue dans la mémoire FIFO (6) et l'insère à l'aide d'un multiplexeur (12) dans au moins un créneau partiel de la séquence marquée du signal numérique retardé à la place de la séquence initiale du signal.

2. Agencement de circuit selon la revendication 1, caractérisé en ce que, dans le générateur de séquences (8), le signal raidi est généré par l'addition du signal numérique retardé à sa deuxième dérivée.

3. Agencement de circuit selon la revendication 2, caractérisé en ce que, lors de l'addition, une pondération des deux composantes du signal est opérée en fonction de l'importance du raidissement souhaité des flancs.

4. Agencement de circuit selon la revendication 3, caractérisé en ce que la pondération est opérée en fonction de la longueur de la séquence indiquée par le signal de marquage, de telle manière que des raidissements plus importants soient effectués pour des longueurs de séquence plus courtes et des raidissements moins importants pour des longueurs de séquence plus longues.

5. Agencement de circuit selon l'une des revendications 1 à 4, caractense en ce que le générateur de séquences (8) comporte un comparateur (12) qui, pendant la séquence indiquée par le signal de marquage retardé, compare le signal raidi avec la valeur initiale du signal numérique retardé et la valeur finale lue dans la mémoire FIFO et ne déclenche une commutation du multiplexeur (12) sur le signal raidi que lorsque celui-ci présente une valeur d'amplitude qui se situe entre la valeur initiale et la valeur finale et en ce que le multiplexeur (12), pendant le reste des créneaux de temps de la séquence indiquée par le signal de marquage, est commuté à la valeur initiale pendant sa première moitié et à sa valeur finale pendant sa deuxième moitié.

6. Agencement de circuit selon la revendication 5, caractérisé en ce que, dans le générateur de séquences (8) est déterminé, par comparaison de la valeur finale lue dans la mémoire FIFO (6) avec la valeur initiale du signal numérique retardé, dans quelle direction le flanc de signal contenu dans la séquence s'étend et en ce que le générateur de séquences (8) compare en permanence, respectivement, deux valeurs successives du signal raidi généré par celui-ci et remplace la deuxième valeur de comparaison respective dans le signal raidi par la première, tant que la deuxième valeur ne s'écarte pas de la première dans la direction du tracé du flanc du signal.

7. Agencement de circuit selon la revendication 1, caractérisé en ce que, dans la mémoire FIFO (6), est également sauvé, au moment de la fin de la séquence non retardée, un signal d'information qui indique la durée de la séquence, en ce que le signal raidi est généré à l'aide d'au moins un compteur (23) dans le générateur de séquences (22) de telle manière que le compteur, au début de la séquence, soit réglé à l'aide du signal d'information lu dans la mémoire FIFO sur une valeur initiale appropriée, en ce que le compteur (23), pendant la séquence, continue de compter à chaque nouvelle valeur de balayage, en ce que différents états du compteur sont décodés et en ce qu'aux moments de décodage, des différences de la valeur initiale et de la valeur finale du signal à raidir qui représentent le signal raidi sont produites à l'aide d'une unité arithmétique (24).

8. Agencement de circuit selon l'une des revendications 1 à 7, caractérisé en ce qu'il est formé dans le détecteur de flancs (1) la première dérivée du signal à raidir qui détermine le montant de la première dérivée et est comparée avec une valeur seuil et en ce que le détecteur de flancs génère le signal de marquage pendant les périodes au cours desquelles le montant de la première dérivée dépasse la valeur seuil.

9. Agencement de circuit selon la revendication 8, caractérisé en ce que le niveau de la valeur seuil varie en permanence en fonction du niveau des variations d'amplitude dans le signal à raidir.
